# EUROPEAN PATENT APPLICATION

(11) **EP 1 978 388 A2**
(43) Date of publication of application: **08.10.2008**
(21) Application number: 08103366.4
(22) Date of filing: 03.04.2008
(51) Int. Cl.: G02B 6/42, H01L 33/00

(54) **Photoelectric element package**

(30) Priority: 04.04.2007 TW 96112115
(71) Applicant: AmTRAN Technology Co. Ltd., Chung Ho City, Tapei, Taiwan (TW)
(72) Inventor: Yu, Wen-Ping, TAIPEI CITY (TW)
(74) Representative: Cabinet Plasseraud

(57) **Abstract**

A package structure for optical-electric element includes a first case and a second case. The first case is fixed on a substrate and the second case is assembled with the first case. The first case has an inner space for arranging a light emitting element and a driving clement. The second case has a connecting ring for receiving an external component and a lens which is arranged in the bottom of the connecting ring for delivering the light emitting from the light emitting element to the external component.

## Description

### BACKGROUND OF THE INVENTION

### Field of Invention

The present invention relates to a photoelectric element package. More particularly, the present invention relates to a photoelectric element package without metal pins.

### Related Art

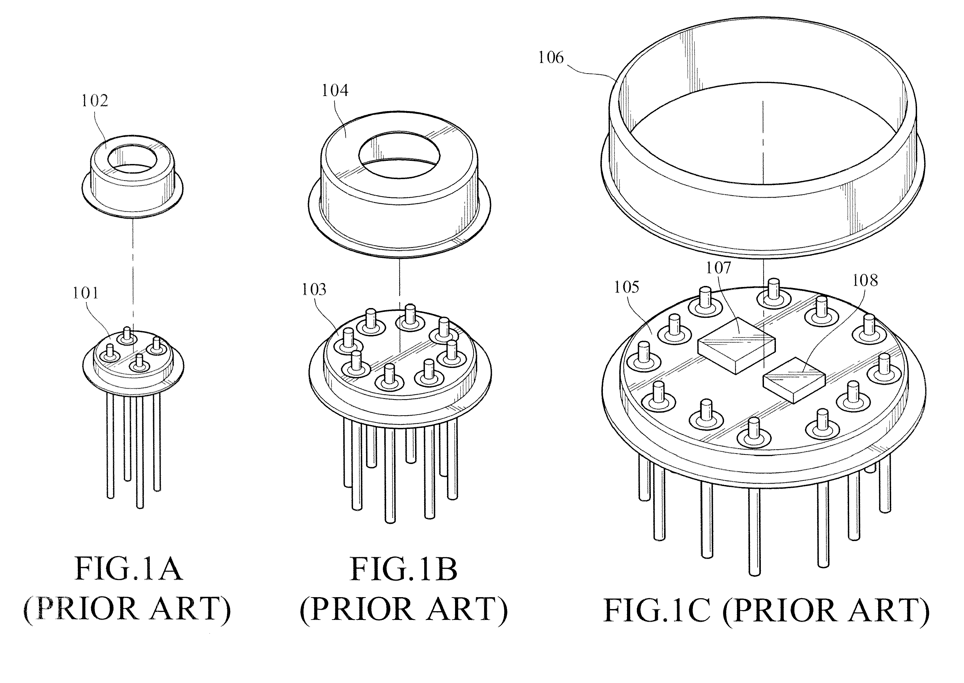

A photoelectric element as shown in FIGs. 1A-1C is disclosed in the conventional art. As shown in FIG. 1A, the photoelectric element is mainly constituted by a casing 101 and a header 102 joined with the casing 101. In sake of the air-tightness required on the conventional photoelectric element package, a process using metal and glass together is adopted in the structure of the header design, such that metal pins can be fixed on the header 102. The metal pins are further connected to a printed circuit board (PCB), such that the electronic elements on the PCB are electrically connected to the photoelectric element.

As shown in FIG. 1C, a light-emitting element integrated by a laser diode 107 and a drive element 108 is disposed in a space enclosed by the metal pins above the header. After the light-emitting element is soldered to the metal pins above the header by a gold wire, and after the metal pins below the header are connected to an external circuit, the electronic signals are transmitted as optical signals through the operation of the photoelectric element.

As described above, the metal pins below the header 102 are the only part connected to the external circuit. Therefore, if it is intended to make different circuit connections with the external circuit, different pins should be designed according to different requirements. As shown in FIG. 1B, a header 104 has eight pins, and a header 106 shown in FIG. 1C has ten pins. As the number of the metal pins in the header increases, the size of the header becomes larger, and the increasing size of a casing 103 and a casing 105 also go against the miniaturizing development trend of the consumptive products recently. Moreover, the light-emitting element is connected to the metal pins above the header by the gold wire, but the gold wire made of gold is quite expensive, such that the element price is increased correspondingly. Meanwhile, as the number of the metal pins increases, the soldering procedures become more complicated, thus being not beneficial for a mass production in the consumptive market.

### SUMMARY OF THE INVENTION

The present invention is mainly directed to providing a photoelectric element package.

According to an embodiment of the present invention, the photoelectric element package is used for packaging a light-emitting unit to be connected with an external element and includes: a substrate; a first casing fixed on the substrate and having an internal space and a first header, wherein the light-emitting unit is disposed on the substrate in the internal space of the first casing; a second casing having a second header joined with the first header and a collar for carrying the external element; and a lens disposed at the bottom of the collar of the second casing for transmitting the light emitted by the light-emitting element to the external element.

According to another embodiment of the present invention, the photoelectric element package is used for packaging a light-emitting unit to be connected with an external element and includes: a substrate; a casing fixed on the substrate and having an internal space and a collar, wherein the light-emitting unit is disposed on the substrate in the internal space of the casing, and the collar is used for carrying the external element; and a lens disposed at the bottom of the collar of the casing for transmitting the light emitted by the light-emitting element to the external element.

In the embodiment of the present invention, a header structure of the conventional element is abandoned. Instead, the light-emitting element and the drive element in the photoelectric element are integrated on a circuit board, such that the abundant soldering operations in the conventional method are reduced, and the desired circuit can be disposed on the circuit board according to the actual demand of the circuit, thereby improving the completeness and integrity of the system. Moreover, the conventional package requires a great deal of human force, thus being not beneficial for a mass production, while the structure disclosed in the present invention can be applied in the packaging process of a printed circuit board, thereby realizing an automatic production.

The above summary of the present invention and the following detailed description of the present invention are given for demonstrating and explaining the present invention, and for providing the further explanation of the claims of the present invention.

Further scope of applicability of the present invention will become apparent from the detailed description given hereinafter. However, it should be understood that the detailed description and specific examples, while indicating preferred embodiments of the invention, are given by way of illustration only, since various changes and modifications within the spirit and scope of the invention will become apparent to those skilled in the art from this detailed description.

### BRIEF DESCRIPTION OF THE DRAWINGS

The present invention will become more fully understood from the detailed description given herein below for illustration only, and thus are not limitative of the present invention, and wherein:
FIGs. 1A-1C are schematic views of a photoelectric element package according to the conventional art;
FIG. 2 is a schematic view of a photoelectric element package according to a first embodiment of the present invention; and
FIG. 3 is a schematic view of a photoelectric element package according to a second embodiment of the present invention.

### DETAILED DESCRIPTION OF THE INVENTION

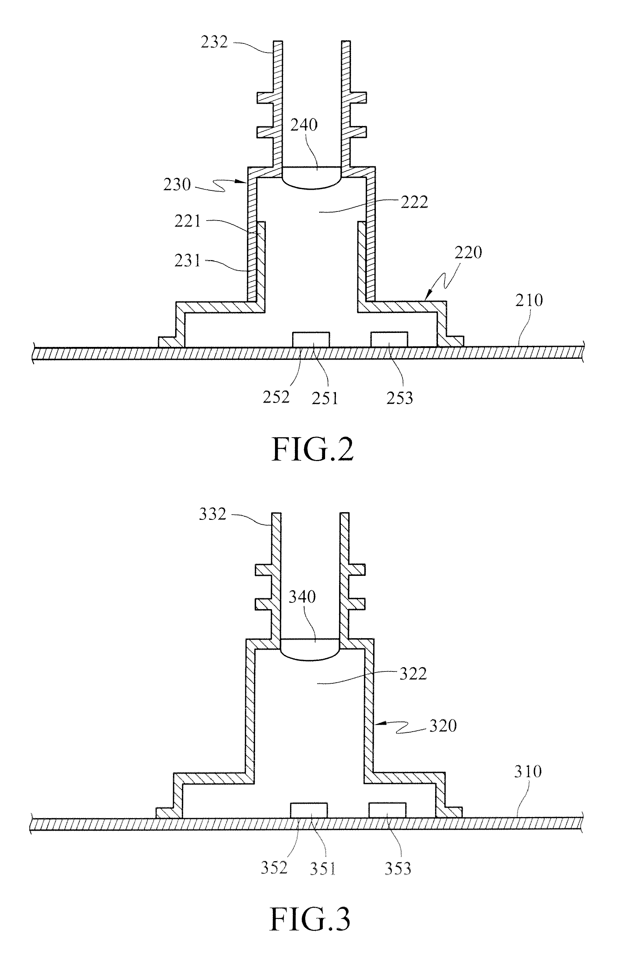

FIG. 2 is a schematic view of a photoelectric element package according to a first embodiment of the present invention. As shown in FIG. 2, the photoelectric element package 200 includes a substrate 210, a first casing 220, a second casing 230, and a lens 240.

The substrate 210 is usually a printed circuit board carrying circuit elements for processing and operating electronic signals. A light-emitting unit is disposed on the substrate 210, and includes a light-emitting element 251 and a drive element 253.

The first casing 220 is fixed on the substrate 210, and usually the first casing 220 is fixed on the substrate by means of bonding. Certainly, depending on different materials and functions of the casing, the casing can also be fixed on the substrate by means of soldering. The first casing 220 has a first header 221 and an internal space 222. The light-emitting unit is disposed on the substrate in the internal space 222 of the first casing 220.

The second casing 230 has a second header 231 and a collar 232, in which the second header 231 of the second casing 230 is joined with the first header 221. In this embodiment, the second header 231 and the first header 221 are joined by means of bonding, and certainly, other joining manners can be adopted, such as a swiveling or an engaging manner. The second casing has a collar 232 for carrying an external element such as an optical fiber. In this preferred embodiment, the first casing 220 and the second casing 230 are hollow column-shaped, and certainly can also be other hollow structures.

A lens 240 is disposed at the bottom of the collar 232 of the second casing 230, for refracting and transmitting the light emitted by the light-emitting element 251 to the optical fiber, such that the optical fiber fixed in the collar 232 transmits the light emitted by the light-emitting element 251 to a remote apparatus. The wavelength and other features of the light-emitting element should be taken into account when selecting a size and a curvature of the lens, so as to correctly transmit the light into the optical fiber.

In this embodiment, the light-emitting element 251 is a laser diode. The light-emitting element 251 is disposed in a first position 252 on the substrate 210. The first position 252 is in the internal space 222 of the first casing 220, such that the light emitted by the light-emitting element 251 is not prevented by the inner wall of the first casing 220 from being transmitted to the external element such as the optical fiber.

FIG. 3 is a schematic view of a photoelectric element package according to a second embodiment of the present invention. As shown in FIG. 3, the photoelectric element package 200 includes a substrate 310, a casing 320, and a lens 340.

The substrate 310 is usually a printed circuit board carrying circuit elements for processing and operating electronic signals. A light-emitting unit is disposed on the substrate 310, and includes a light-emitting element 351 and a drive element 353.

The casing 320 is fixed on the substrate 310, and has an internal space 322. In this embodiment, the casing 320 is hollow column-shaped. The light-emitting element 351 and the drive element 353 are disposed on the substrate in the internal space 322 of the casing 320. The casing 320 further has a collar 332 for carrying an optical fiber.

The lens 340 is disposed at the bottom of the collar 332 of the casing 320 for transmitting the light emitted by the light-emitting element 351, such that the optical fiber fixed in the collar 332 transmits the light emitted by the light-emitting element 351 to a remote apparatus.

In this embodiment, the light-emitting element 351 is a laser diode disposed in a first position 352 on the substrate 310. The first position is in the internal space 322 of the casing 320, such that the light emitted by the light-emitting element 351 is not prevented by the inner wall of the casing 320 from being transmitted to the optical fiber.

In the prior art, the photoelectric element is disposed on the header, and gold wires are needed to be connected with metal pins thereon, and the photoelectric converting and transmitting function can be realized after performing an air-tight packaging and then soldering the metal pins below the header with the circuit board. In the present invention, the photoelectric element is directly soldered and packaged on the circuit board, such that the complicated procedures are greatly reduced, and the desired circuit can be disposed on the circuit board according to the actual demand of the circuit, thereby improving the completeness and integrity of the system.

Furthermore, human force is needed to assembling the casing and the header in the conventional package, and the assembled elements are inserted in the circuit board for being soldered. This process needs a great deal of human force, thus being not beneficial for a mass production. The structure disclosed by the present invention can be applied in the packaging process of a printed circuit board, thereby realizing an automatic production.

The invention being thus described, it will be obvious that the same may be varied in many ways. Such variations are not to be regarded as a departure from the spirit and scope of the invention, and all such modifications as would be obvious to one skilled in the art are intended to be included within the scope of the following claims.

## Claims

1. A photoelectric element package, for packaging a light-emitting unit to be connected with an external element, the package comprising:
a substrate, to which the light-emitting unit is electrically connected;
a first casing, fixed on the substrate and having an internal space and a first header, wherein the light-emitting unit is disposed on the substrate in the internal space of the first casing;
a second casing, having a second header joined with the first header and a collar for carrying the external element; and
a lens, disposed at the bottom of the collar of the second casing for transmitting the light emitted by the light-emitting unit.

2. The package as claimed in claim 1, wherein the light-emitting unit comprises a laser diode and a drive element.

3. The package as claimed in claim 1, wherein the first casing and the second casing are hollow column-shaped.

4. The package as claimed in claim 1, wherein the first casing is fixed on the substrate by means of bonding.

5. The package as claimed in claim 1, wherein the first casing and the second casing are joined by means of bonding.

6. The package as claimed in claim 1, wherein the first casing and the second casing are joined by means of soldering.

7. An photoelectric element package, for packaging a light-emitting unit to be connected with an external element, comprising:
a substrate, to which the light-emitting unit is electrically connected;
a casing, fixed on the substrate and having an internal space and a collar, wherein the light-emitting unit is disposed on the substrate in the internal space of the first casing, and the collar is used for carrying the external element; and
a lens, disposed at the bottom of the collar of the casing for transmitting light emitted by the light-emitting unit.

8. The package as claimed in claim 7, wherein the light-emitting unit comprises a laser diode and a drive element.

9. The package as claimed in claim 7, wherein the casing is hollow column-shaped.

10. The package as claimed in claim 7, wherein the casing is fixed on the substrate by means of bonding.
